# EUROPÄISCHE PATENTANMELDUNG

(11) **EP 2 868 601 A1**
(43) Veröffentlichungstag der Anmeldung: **06.05.2015**
(21) Anmeldenummer: 13005442.2
(22) Anmeldetag: 20.11.2013
(51) Int. Cl.: B65G 47/29

(54) **Fördervorrichtung zur Förderung von Werkstücken, insbesondere Leiterplatten, in Förderrichtung entlang einer Förderstrecke**

(30) Priorität: 31.10.2013 DE 102013112056
(71) Anmelder: Viscom Ag, 30455 Hannover (DE)
(72) Erfinder: Heuser, Martin, 30519 Hannover (DE)
(74) Vertreter: Wagner, Carsten

(57) **Zusammenfassung**

Die Erfindung betrifft eine Fördervorrichtung (2) zur Förderung von Werkstücken (4,6,8), insbesondere Leiterplatten, in Förderrichtung (T) entlang einer Förderstrecke. Die Fördervorrichtung (2) ist ausgestattet mit ersten Fördermitteln (18) wie auch mit zweiten Fördermitteln (22) zur Werkstückförderung entlang einer ersten bzw. zweiten Teilstrecke (20,24) der Förderstrecke (10), wobei der ersten Teilstrecke (20) Werkstücke (4,6,8) über die zweite Teilstrecke (24) zugeführt werden. Die Erfindung ist gekennzeichnet durch Separationsmittel (26), die wenigstens abschnittsweise entlang der ersten Teilstrecke (20) ein Werkstück (4,6,8) von einem in Förderrichtung (T) dem Werkstück (4,6,8) nachfolgendes Werkstück (6,8) separieren, wobei diese wenigstens einen Abstandhalter (28) aufweisen, der derart bewegbar und durch Steuerungsmittel derart steuerbar ist, dass der Abstandhalter (28) nach Passieren der Anfangsposition (30) durch das Werkstück (4,6,8) in einen Aktivmodus wechselt, in dem es dem Werkstück (4,6,8) in Förderrichtung (T) nachgeordnet folgt und dabei zwischen dem Werkstück (4,6,8) und dem diesem Werkstück (4,6,8) in Förderrichtung T nachgeordneten Werkstück (6,8) einen Mindestabstand ausbildet, und bei Erreichen der Endposition (32) in einen Inaktivmodus wechselt, in dem der Abstandshalter (28) in die Anfangsposition (30) zurückkehrt.

## Beschreibung

Die Erfindung betrifft eine Fördervorrichtung zur Förderung von Werkstücken, insbesondere Leiterplatten, in Förderrichtung entlang einer Förderstrecke.

Fördervorrichtungen der betreffenden Art werden zu unterschiedlichen Zwecken und in unterschiedlichen Bereichen eingesetzt. Beispielsweise dienen Fördervorrichtungen innerhalb einer Fertigungslinie dazu, Werkstücke von einer Bearbeitungsstation zu einer weiteren Bearbeitungsstation zu fördern. Dabei ist die Förderstrecke einer betreffenden Fördervorrichtung in Teilstrecken unterteilt, denen Fördermittel zugeordnet sind, um ein Werkstück in Förderrichtung entlang der Teilstrecke zu fördern.

Fördervorrichtungen der betreffenden Art sind aus dem Stand der Technik bekannt und weisen zunächst erste Fördermittel zur Werkstückförderung entlang einer ersten Teilstrecke der Förderstrecke auf. Ferner weisen diese Fördervorrichtungen zweite Fördermittel zur Werkstückförderung entlang einer zweiten Teilstrecke der Förderstrecke auf. Dabei ist die zweite Teilstrecke der ersten Teilstrecke der Förderstrecke in Förderrichtung, insbesondere direkt, vorgeordnet, um der ersten Teilstrecke Werkstücke zuzuführen. In diesem Zusammenhang ist unter dem Ausdruck direkt vorgeordnet zu verstehen, dass zwischen erster und zweiter Teilstrecke der Förderstrecke keine weitere Teilstrecke mit Fördermitteln zur Werkstückförderung angeordnet ist.

Die bekannten Fördervorrichtungen der betreffenden Art weisen jedoch Prinzip bedingt den Nachteil auf, dass eine Abweichung der Fördergeschwindigkeiten der Werkstückförderung durch erste und zweite Fördermittel dazu führen, dass entweder der geometrische Abstand in Förderrichtung zwischen den Werkstücken unangemessen groß wird oder die Werkstücke insbesondere im Übergangsbereich zwischen erster und zweiter Teilstrecke miteinander kollidieren und dabei beschädigt werden können. Insofern weisen die bekannten Fördervorrichtungen der betreffenden Art den Nachteil einer geringen Werkstückförderrate bzw. den Nachteil einer hohen Ausschussrate von Werkstücken auf. Vorgenannte Nachteile führen zu Einbußen des wirtschaftlichen Betriebs einer entsprechenden Fördervorrichtung.

Eine bekannte Lösung der Probleme ist durch die Einrichtung eines Werkstückzwischenspeichers (Puffer) gegeben, dem Werkstücke von der Förderstrecke zugeführt werden, sofern die eine Gefahr besteht, dass ein Mindestabstand zwischen Werkstücken, die entlang der Förderstrecke einander nachgeordneten sind, unterschritten wird, wodurch diese miteinander zu kollidieren drohen. Die in dem Werkstückzwischenspeicher befindlichen Werkstücke werden zu einem späteren Zeitpunkt der Förderstrecke zugeführt.

Ferner sind Lösungen bekannt, die Teilstrecken hinsichtlich ihrer Fördergeschwindigkeit genauer zu synchronisieren oder zu einer großen Förderstrecke zu verbinden bzw. die Anzahl der Fördermittel zu reduzieren.

Der Erfindung liegt die Aufgabe zugrunde, eine Fördervorrichtung der im Oberbegriff des Anspruchs 1 genannten Art anzugeben, die derart eingerichtet und ausgebildet ist, dass sie eine Verbesserung der Förderung von Werkstücken entlang einer in Teilstrecken untergliederten Förderstrecke mit einer erhöhten Werkstückförderrate ermöglicht.

Die Erfindung löst sich von dem Gedanken, die Fördermittel zu manipulieren bzw. Werkstücke bei einer Kollisionsgefahr der Förderstrecke zu entnehmen.

Zudem wendet sich die Erfindung von dem Gedanken ab, eine Förderstrecke bzw. Teilstrecken einer Förderstrecke redundant auszuführen, um Kollisionen zwischen den Werkstücken zu vermeiden bzw. die Förderrate von Werkstücken zu erhöhen.

Der Erfindung liegt vielmehr der Gedanke zugrunde, mit einfachen Mitteln bzw. geringem Aufwand eine Verbesserung der Förderung von Werkstücken entlang einer Förderstrecke zu realisieren.

Sie wendet sich jedoch davon ab, die Förderrate auf ein gemeinsames geringes Niveau zu senken, um das Kollisionsproblem zwischen den Werkstücken zu beheben. Gleichfalls entfernt sich die Erfindung von dem Gedanken, die zu fördernden Werkstücke konstruktiv anzupassen und dadurch zur Vermeidung von Beschädigungen entsprechend kollisionsschadenresistent auszubilden bzw. zu armieren.

Die Erfindung löst die Aufgabe vielmehr dadurch, während der Förderung entlang wenigstens einer Teilstrecke wenigstens temporär einen Abstandhalter wenigstens abschnittsweise zwischen einem Werkstück und einem dem Werkstück in Förderrichtung nachfolgendem Werkstück einzubringen, um dadurch die vorgenannten Werkstücke mit einem Mindestabstand, beispielsweise und insbesondere auf im Wesentlichen mechanische Art und Weise, zueinander zu beabstanden.

Dazu löst sich die Erfindung von der Idee, eine starre Positionierung der Werkstücke nach Art eines Rasters vorzugeben, sondern verfolgt den Ansatz, die Werkstücke wahlfrei unter Einhaltung eines Mindestabstandes zwischen zwei Werkstücken wenigstens einer der Teilstrecken der Förderstrecke zuführen zu können.

Zur Lösung der Aufgabenstellung sieht die Erfindung Separationsmittel vor, die wenigstens abschnittsweise entlang der ersten Teilstrecke ein Werkstück von einem in Förderrichtung nachfolgenden Werkstück separieren. Dazu weisen die Separationsmittel wenigstens einen Abstandhalter auf, der in Förderrichtung zwischen einer Anfangsposition und einer in Förderrichtung dazu beabstandeten Endposition derart bewegbar und dessen Bewegung durch Steuerungsmittel derart steuerbar ist, dass der Abstandhalter nach Passieren der Anfangsposition durch das Werkstück in einen Aktivmodus wechselt, in dem es dem Werkstück in Förderrichtung nachgeordnet folgt und dabei zwischen dem Werkstück und dem ihm nachgeordneten Werkstück einen Mindestabstand ausbildet, und bei Erreichen der Endposition in einen Inaktivmodus wechselt, in dem der Abstandshalter in die Anfangsposition zurückkehrt, ohne jedoch mit einem der Werkstücke zu kollidieren (wodurch der Abstandshalter kollisionsfrei in die Anfangsposition zurückkehrt).

Im Inaktivmodus bildet der Abstandshalter keinen Mindestabstand zwischen einem Werkstück und dem in Förderrichtung dem Werkstück nachfolgendem Werkstück aus (wodurch eine Mindestbeabstandung der vorgenannten Werkstücke zueinander durch den Abstandshalter aufgehoben ist).

Insofern ist - wie bereits zuvor beschrieben - das auslösende Ereignis für die Aktivierung des Abstandshalters zur Ausbildung des vorgenannten Mindestabstandes, also der Wechsel in den Aktivmodus, dadurch bestimmt, dass das Werkstück die Anfangsposition des Abstandshalters passiert. Demgemäß ist das beendende Ereignis zur Deaktivierung des Abstandshalters, also der Wechsel des Abstandshalters in den Inaktivmodus, dass das Werkstück die Endposition des Abstandshalters passiert.

Dabei sind erfindungsgemäß Anfangs- und Endposition des Abstandshalters derart bestimmt, dass die eine Kollision zwischen den betreffenden Werkstücken durch Ausbildung eins Mindestabstandes zwischen diesen entlang der ersten Teilstrecke unterbunden ist. Beispielsweise und insbesondere sind Anfangs- und Endposition für den Abstandshalter entsprechend an den Enden der ersten Teilstrecke befindlich.

In einem kollisionsfreien Bereich ist erfindungsgemäß verhindert, dass der Abstandshalter mit einem Werkstück kollidiert.

Erfindungsgemäß ist damit auf einfache und wirkungsvolle Art und Weise erreicht, dass ein Werkstück über die erste Teilstrecke der zweiten Teilstrecke zuführbar ist, ohne dass es einer präzisierten Abstimmung der Fördergeschwindigkeiten zwischen den Fördermitteln der ersten und zweiten Teilstrecken der Förderstrecke bedarf. Insofern sind Unterschiede in den Fördergeschwindigkeiten oder der Art der Förderung zwischen den Teilstrecken der Förderstrecke, beispielsweise einer kontinuierlichen oder einer diskontinuierlichen bzw. intermittierenden Förderung auf einfache wie auch kostengünstige Art und Weise unter Meidung einer Kollision zwischen den Werkstücken ausgleichbar.

Dadurch entfällt der Aufwand für eine Synchronisation der Teilstrecken der Förderstrecke aufeinander.

Ferner entsteht durch die Erfindung der Vorteil, dass bei Teilstrecken der Förderstrecke, denen außerhalb der Erfindung ein Werkstück lediglich zu einem Zeitpunkt zugeführt werden kann, zu dem die Teilstrecke Werkstückfrei ist, ein Zeitverzug entfällt. Ein Werkstück kann unter Anwendung der Erfindung dem auf der Teilstrecke befindlichen Werkstück nachgeführt werden, ohne dass eine Kollision zwischen den Werkstücken besteht.

Zudem ist vorteilhafter Weise erreicht, dass ein ausreichender Mindestabstand zwischen einem Werkstück und einem in Förderrichtung dem Werkstück nachgeordneten Werkstück zur Vermeidung einer Kollision zwischen den Werkstücken nicht unterschritten wird. Insofern unterbindet der Abstandshalter eine ungewünschte Annäherung eines Werkstücke zu einem in Förderrichtung dem Werkstück, insbesondere direkt, nachgeordnetem Werkstück, wodurch ein Mindestabstand zwischen den vorgenannten Werkstücken gewahrt bleibt.

Überdies ist erfindungsgemäß neben wirtschaftlichen Vorteilen bei der Werkstückförderung der Werkstücke erreicht, dass die Instandhaltbarkeit einer erfindungsgemäßen Fördervorrichtung kostengünstig und mit geringem zeitlichem Aufwand realisiert werden kann.

Im Sinne der Erfindung ist in Bezug auf die Beabstandung von Werkstücken zueinander unter dem Ausdruck "direkt nachgeordnet" zu verstehen, dass kein weiteres zu förderndes Werkstück in Förderrichtung zwischen den betreffenden Werkstücken angeordnet ist.

Des Weiteren ist im Rahmen der Erfindung ein Werkstück ein einstückiges, einteiliges wie auch mehrteiliges Bauteil zu verstehen. Insofern kann ein Bauteil auch aus mehreren Bestandteilen wie auch Modulen bestehen. Ein Bauteil kann daher im Sinne der Erfindung auch nach Art einer Leiterplatte, die wiederum mit Bauteilen bestückt wie auch unbestückt sein kann, ausgeführt sein, und umfasst ebenfalls sogenannte Wafer oder Halbleiter.

Eine besondere Bedeutung kommt der Erfindung bei vergleichsweise gering gewichtigen Werkstücken zu, da diese zu einem Schlupf neigen, so dass sich eine Differenz zwischen der durch die Fördermittel erzeugten Werkstückförderung bzw. der Fördergeschwindigkeit und der Geschwindigkeit des Werkstückes in Förderrichtung ergibt. Der vorgenannte Schlupf begünstigt eine ungewünschte Annäherung von aufeinanderfolgenden Werkstücken zueinander, die wiederum zu einer Erhöhung des Kollisionsrisikos führt.

Im Sinne der Erfindung wird unter einer Bearbeitungsstation eine Einrichtung/Vorrichtung verstanden, zu deren Funktionsumfang das Prüfen bzw. Bearbeiten eines Werkstückes gehört. Demgemäß ist im Sinne der Erfindung eine Bearbeitung eines Werkstückes nicht zwingend auf eine Veränderung des Werkstückes gerichtet.

Des Weiteren beziehen sich die Ausführungen zur Erfindung stets auf die erfindungsgemäße Fördereinrichtung in einem Betriebszustand in dem sie zur Zweckerfüllung eingerichtet ist und entsprechend verwendbar ist bzw. verwendet wird. Abweichungen dazu ergeben sich durch explizite Angaben oder durch den betreffenden Sinnzusammenhang.

Erfindungsgemäß ist unter einer Förderrichtung die Richtung der Werkstückförderung zu verstehen, in der die Werkstücke zu deren bestimmungsgemäßen Transport entlang der Förderstrecke von einem Förderstreckenanfang zu einem Förderstreckenende gefördert werden. Eine Förderung in entgegengesetzter Richtung zur Förderrichtung ist erfindungsgemäß zwar erfasst, wobei diese im Weiteren nicht explizit erläutert wird.

Ferner ist im Sinne der Erfindung durch Steuerungsmittel auch die Funktion einer Regelung umfasst. Die Realisierung der Steuerungsmittel kann dabei mechanisch wie auch vorzugsweise signaltechnisch bzw. auf elektrischer/elektronischer (wie auch in einer Kombination der vorgenannten Realisierungsformen) erfolgen, wobei die entsprechenden Komponenten steuerungs- bzw. signaltechnisch mit den Steuerungsmitteln verbunden sind, ohne dass dies explizit beschrieben ist.

Die Ansteuerung durch die Steuerungsmittel kann beispielsweise und insbesondere unter Zuhilfenahme eines Aktors bzw. Antriebs erfolgen, der wiederum zur Erzeugung einer Antriebsbewegung für die Ansteuerung einen elektrisch betrieben Antriebsmotor aufweisen kann, um einen Modus-/Zustandswechsel zu bewirken. Eine Antriebsbewegung kann jedoch ebenfalls mittels hydraulischer bzw. pneumatischer Aktoren/Stellglieder erfolgen.

Ferner ist es möglich, dass eine mechanische bzw. kinematische Steuerung erfolgt, die beispielsweise und insbesondere ereignisgesteuert ist.

Aus verschiedenen Gründen kann es erforderlich sein, dass die Förderung eines Werkstückes entlang wenigstens einer Teilstrecke der Förderstrecke durch Förderunterbrechungen bzw. durch zeitweise Variation der Fördergeschwindigkeit intermittierend erfolgt, um beispielsweise und insbesondere eine Bearbeitung an dem Werkstück, vorzugsweise eine Prüfung an dem Werkstück, vornehmen zu können.

Insofern ist in einer vorteilhaften Weiterbildung der Erfindung vorgesehen, dass die Werkstückförderung wenigstens durch die ersten Fördermittel intermittierend ist, wobei die Förderung des Werkstückes durch die ersten Fördermittel bei Erreichen einer Ruheposition, in der eine Bearbeitungsstation, insbesondere eine Prüfstation, das Werkstück in einem Bearbeitungszeitraum bearbeitet bzw. prüft, die Förderung des Werkstückes in Förderrichtung während des Bearbeitungszeitraumes aussetzt oder mit einer geänderten, insbesondere geringeren, Fördergeschwindigkeit des Werkstückes erfolgt.

Dadurch entsteht der Vorteil, dass eine Bearbeitung bzw. Prüfung eines Werkstückes nicht einer konstanten Fördergeschwindigkeit anzupassen ist bzw. die Fördergeschwindigkeit entlang der gesamt Förderstrecke bzw. wenigstens einer der Teilstrecken der Förderstrecken nicht auf die Bearbeitungs- bzw. Prüfstation abzustimmen ist. Ferner ist eine redundante Anordnung von Bearbeitungs- bzw. Prüfstationen entbehrlich.

Die Werkstückförderung entlang einer Förderstrecke bzw. einer Teilstrecke der Förderstrecke kann auf unterschiedliche Art und Weise realisiert werden. Beispielsweise und insbesondere ist es möglich, Linearführungen vorzusehen, um die betreffenden Förder- bzw. Teilstrecken auszubilden. Dabei ist es möglich, die Werkstücke auf einem unter ihnen gebildeten Luftpolster zu fördern. Ferner sind neben luft- bzw. fluidbasierten Lösungen auch magnet- wie auch induktionsbasierte Lösungen erfindungsgemäß umfasst.

Dazu ist in einer weiteren vorteilhaften Weiterbildung der Erfindung vorgesehen, dass wenigstens die ersten Fördermittel ausgebildet sind nach Art eines Stetigförderers, und insbesondere wenigstens ein, vorzugsweise endloses, Förderband aufweisen, das eine Förderbewegung für die Werkstückförderung durch eine Umlaufbewegung um wenigstens zwei zueinander in Förderrichtung beabstandete, insbesondere achsparallele, Rollen erzeugt. Ein Förderband sind beispielsweise und insbesondere derart eingerichtet und ausgebildet, dass, insbesondere bei einer im Wesentlichen horizontalen Ausrichtung des Förderbands, auf der in vertikaler Richtung nach außen gerichteten Fläche eine Förderfläche für das Werkstück ausgebildet ist, auf die das Werkstück zu dessen Förderung direkt oder indirekt, beispielsweise unter Verwendung einer Aufnahme, anordnenbar ist.

Berührungsempfindliche Werkstücke wie auch Werkstücke, deren Bearbeitung bzw. Prüfung eine im Wesentlichen freie Zugänglichkeit ihrer Oberseite bzw. ihrer Unterseite erfordern, können beispielsweise mittels ihrer äußeren Ränder bzw. ihren äußeren Randbereichen gefördert werden.

Dazu sieht eine vorteilhafte Weiterbildung der Erfindung vor, dass wenigstens die ersten Fördermittel wenigstens ein erstes, insbesondere endloses, Förderband und wenigstens ein dazu quer zur Förderrichtung beabstandetes zweites , insbesondere endloses, Förderband aufweisen, deren jeweilige umlaufende Bewegung für die Werkstückförderung miteinander synchronisiert sind. Die Werkstückförderung erfolgt dabei nach den zuvor erläuterten Prinzipien.

Für eine möglichst kompakte Bauweise ist in einer weiteren vorteilhaften Weiterbildung der Erfindung vorgesehen, dass der Abstandhalter wenigstens in seinem Aktivmodus quer zur Förderrichtung zwischen dem ersten und dem zweiten Förderband, insbesondere gleich beabstandet zu den Förderbändern, angeordnet ist.

Eine Anordnung des Abstandhalters unter gleicher Beabstandung zu den quer zur Förderrichtung direkt zum Abstandhalter benachbarten Förderbändern ermöglicht es, dass der Abstandhalter konstruktiv einfach ausgeführt sein kann und zudem eine ungewünschte Bewegung des Werkstückes, insbesondere relativ zur Förderstrecke, wie auch des dazu direkt nachfolgendem Werkstück, insbesondere quer zur Förderrichtung, verhindert ist.

Eine konstruktive Vereinfachung des Bewegungsantriebs des Abstandhalters für eine Bewegung in Förderrichtung kann dadurch erreicht werden, dass die Bewegung des Abstandhalters, wenigstens in dessen Aktivmodus, mit der Werkstückförderung der ersten Fördermittel synchronisiert ist. Insofern ist es vorteilhafterweise ebenfalls möglich, den Antrieb des Abstandhalters mit dem Antrieb der Fördermittel antriebstechnisch zu koppeln bzw. dessen Bewegung anhand der Werkstückförderung der Fördermittel zu steuern. Dadurch entsteht der Vorteil, dass eine Berührung des Abstandshalters mit beispielsweise und insbesondere kollisionsempfindlichen Werkstücken auf Ausnahmen beschränkt bleibt, die u.a. bei vorgenanntem Schlupf entstehen.

Dem Erfindungsgedanken folgend, dass der kürzeste Weg zwischen zwei Punkten eine Gerade ist, sieht eine vorteilhafte Weiterbildung der Erfindung vor, dass die Separationsmittel wenigstens eine Linearführung aufweisen, durch die der Abstandhalter für eine Bewegung zwischen Anfangsposition und Endposition geführt ist. Demgemäß ist der erfindungsgemäße Vorteil kurzer Bewegungs- bzw. Verfahrwege des Abstandhalters erreicht. Ferner kann eine kostengünstige Realisierung vorgenommen werden, indem ggf. auf Serienteile zurückgegriffen werden kann.

In diesem Zusammenhang ist ebenfalls vorteilhafter Weise durch die Erfindung berücksichtigt, dass eine Kollision zwischen zwei Werkstücken dadurch entstehen kann, dass ein Werkstück gegenüber der Werkstückförderung einen Schlupf aufweist, wodurch ein Minimalabstand zwischen zwei Werkstücken unterschritten werden kann und dadurch eine Kollision begünstigt ist. Insofern kann ein aktiver Antrieb des Abstandhalters zu dessen Bewegung in Förderrichtung bzw. zwischen Anfangs- und Endposition, dazu beitragen, dass eine schlupfbedingte Verzögerung der Förderung des Werkstückes im Hinblick auf die Einhaltung eines Mindestabstandes in Förderrichtung zwischen den Werkstücken dadurch korrigierbar ist, indem der Abstandhalter das betreffende Werkstück berührt bzw. mit diesem in mechanischen Kontakt tritt und dieses entsprechend in Förderrichtung bewegt bzw. antreibt. Ferner ist dadurch erreicht, dass eine ungewünschte ungleichförmige Werkstückförderung (z.B. Fördergeschwindigkeitsschwankungen) nicht zu einer Kollision der Werkstücke führt.

Zur Verhinderung derartiger Kollisionsprobleme ist erfindungsgemäß vorgesehen, dass der Abstandhalter die Einhaltung eines Mindestabstandes zwischen einem Werkstück und einem dem Werkstück in Förderrichtung nachgeordnetem Werkstück bewirkt.

Im Rahmen der Erfindung ist berücksichtigt, dass die Separationsmittel, insbesondere elektrisch betriebene, Antriebsmittel zur Erzeugung einer Bewegung des Abstandhalters in Förderrichtung, insbesondere zwischen Anfangsposition und Endposition, aufweisen. Die Antriebsmittel können für die Antriebsbewegung ebenfalls mit Steuerungsmitteln steuerungstechnisch bzw. signaltechnisch verbunden sein, um eine Antriebsbewegung für den Abstandhalter besser regeln bzw. steuern bzw. kontrollieren und mit der gewünschten Werkstückförderung abstimmen zu können.

Das Einbringen eines Abstandshalters in die Bewegungsbahn der vorgenannten Werkstücke zur Ausbildung eines Mindestabstandes kann erfindungsgemäß auf unterschiedliche Art und Weise erfolgen.

Im Rahmen der Erfindung wird ein Werkstück durch die Fördermittel entlang einer Bewegungsbahn bewegt, deren Erstreckung in Förderrichtung durch die Förderstrecke bzw. die Teilstrecken der Förderstrecken bestimmt ist und deren weitere räumliche Dimension durch die Abmessungen des jeweiligen Werkstückes bestimmt ist.

Im Rahmen der Erfindung ist beispielsweise und insbesondere als Aktor, über den der Abstandshalter derart bewegungsführbar ist, eine Schwenkeinrichtung vorgesehen. Dabei ist der Abstandshalter an dem Aktor derart angeordnet, dass dieser mittels einer Schwenkbewegung um eine Schwenkachse im Aktivmodus in die Bewegungsbahn der vorgenannten Werkstücke wenigstens der ersten Teilstrecke zur Ausbildung eines Mindestabstandes zwischen den vorgenannten Werkstücke abschnittsweise eingeschwenkt ist und im Inaktivmodus durch eine Schwenkbewegung aus der Bewegungsbahn ausgeschwenkt ist.

Dazu kann der Aktor auf einfachste Art und Weise eine Führungsstange aufweisen, an dem der Abstandshalter in radialer Richtung zur Längsachse der Führungsstange längserstreckt ist und mit der Bewegungsstange derart bewegungsgekoppelt ist, dass eine erste Schwenkbewegung der Führungsstange um deren Längsachse bewirkt, dass der Abstandshalter in die Bewegungsbahn der Werkstücke einschwenkt und den vorgenannten Mindestabstandes im Aktivmodus ausbildet und eine zweite Schwenkbewegung ein Ausschwenken des Abstandshalters aus der Bewegungsbahn der Werkstücke bewirkt, wodurch die Ausbildung des Mindestabstandes durch den Abstandshalter aufgehoben ist.

Der Abstandshalter kann für dessen Bewegung in Förderrichtung relativ zur vorgenannten Führungsstange bewegt werden oder derart mit der Führungsstange bewegungsgekoppelt sein, dass eine Bewegung der Führungsstange in Förderrichtung ebenfalls eine entsprechende Bewegung des Abstandshalters in Förderrichtung bewirkt, um eine Bewegung zwischen Anfangs- und Endposition des Abstandsalters zu erzeugen.

Vor dem Hintergrund der vorgenannten Realisierungsmöglichkeit des Einbringens eines Abstandshalters in die Bewegungsbahn des betreffenden Werkstückes ist in einer vorteilhaften Weiterbildung der Erfindung vorgesehen, dass die Separationsmittel wenigstens einen Aktor aufweisen, der den Abstandhalter im Aktivmodus zur Ausbildung eines Mindestabstandes zwischen dem Werkstück und dem diesem in Förderrichtung nachgeordnetem Werkstück in die Bewegungsbahn des Werkstückes wenigstens abschnittsweise hineinbewegt und bei Erreichen der Endposition in vertikaler Richtung für eine Bewegung des Abstandhalter von der Endposition in die Anfangsposition aus der Bewegungsbahn des Werkstückes hinausbewegt.

Insofern dient ein Aktor erfindungsgemäß als Antriebsmittel unter anderem auch dazu, Steuersignale der Steuerungsmittel in eine Bewegung für den Abstandshalter umzusetzen bzw. diese zu erzeugen. Demgemäß ist ein Aktor beispielsweise und insbesondere als elektromechanischer Antrieb ausgebildet, wie es ein Hub-/Senk- bzw. Verstellsystem sein kann.

Um den Abstandhalter kollisionsfrei in Förderrichtung von der Endposition in die Anfangsposition zurückführen zu können, ist in einer weiteren vorteilhaften Weiterbildung der Erfindung eine weitere Realisierungsform zu vorgenannter Variante für die Ausbildung eines Aktors dadurch berücksichtigt, dass der Aktor wenigstens eine Hub-/Senkeinrichtung für den Abstandhalter aufweist, die den Abstandhalter im Aktivmodus durch eine Hubbewegung zur Ausbildung eines Mindestabstandes der Werkstücke in vertikaler Richtung anheben, sowie bei Erreichen der Endposition in vertikaler Richtung für eine Bewegung des Abstandhalters von der Endposition in die Anfangsposition aus der Bewegungsbahn, insbesondere unterhalb des nachfolgenden Werkstückes, absenken.

Besondere Vorteile bewirkt die Erfindung durch Anwendung bei einer Bearbeitungsstation. Insofern ist daher in einer weiteren vorteilhaften Weiterbildung der Erfindung eine Bearbeitungsstation für die Werkstückbearbeitung vorgesehen, mit wenigstens ersten Fördermitteln zur Werkstückförderung entlang einer ersten Teilstrecke einer Förderstrecke, denen eine zweite Teilstrecke der Förderstrecke Werkstücke zur Förderung durch die ersten Fördermittel zuführt.

Dabei nutzt eine erfindungsgemäße Bearbeitungsstation die erfindungsgemäßen Bestandteile der vorgenannten erfindungsgemäßen Fördereinrichtung und ist demgemäß gekennzeichnet durch Separationsmittel, die wenigstens abschnittsweise entlang der ersten Teilstrecke der Förderstrecke ein Werkstück von einem in Förderrichtung nachfolgenden Werkstück separieren, wobei die Separationsmittel wenigstens einen Abstandhalter aufweisen, der in Förderrichtung zwischen einer Anfangsposition und einer in Förderrichtung dazu beabstandeten Endposition derart bewegbar und durch Steuerungsmittel derart steuerbar ist, dass der Abstandhalter nach Passieren der Anfangsposition durch das Werkstück in einen Aktivmodus wechselt, in dem es dem Werkstück in Förderrichtung nachgeordnet folgt und dabei zwischen dem Werkstück und dem ihm nachgeordneten Werkstück einen Mindestabstand ausbildet, und bei Erreichen der Endposition in einen Inaktivmodus wechselt und in die Anfangsposition zurückkehrt.

Insofern ist - wie bereits zuvor beschrieben - das auslösende Ereignis für die Aktivierung des Abstandshalters zur Ausbildung des vorgenannten Mindestabstandes, also der Wechsel in den Aktivmodus, dadurch bestimmt, dass das Werkstück die Anfangsposition des Abstandshalters passiert. Demgemäß ist das beendende Ereignis zur Deaktivierung des Abstandshalters, also der Wechsel des Abstandshalters in den Inaktivmodus, dass das Werkstück die Endposition des Abstandshalters passiert.

Dabei sind erfindungsgemäß Anfangs- und Endposition des Abstandshalters derart bestimmt, dass eine Kollision zwischen den betreffenden Werkstücken durch Ausbildung eins Mindestabstandes zwischen diesen entlang der ersten Teilstrecke unterbunden ist. Beispielsweise und insbesondere sind die Anfangs- und Endposition entsprechend an den Enden der Teilstrecke angeordnet.

Dabei kann eine erfindungsgemäße Ausprägung anhand der vorgenannten vorteilhaften Weiterbildungen erfolgen.

Die Erfindung wird nachfolgend anhand der beigefügten Zeichnung näher erläutert, in der ein Ausführungsbeispiel einer erfindungsgemäßen Fördervorrichtung zur Förderung von Werkstücken, insbesondere Leiterplatten, in Förderrichtung entlang einer Förderstrecke (nachfolgend auch verkürzt als Fördervorrichtung bezeichnet) dargestellt sind. Die Erläuterung der Erfindung anhand der Figuren erfolgt anhand der Anwendung der Erfindung bei einer Bearbeitungsstation.

Dabei bilden alle beanspruchten, beschriebenen und in der Zeichnung dargestellten Merkmale für sich genommen sowie in beliebiger Kombination miteinander den Gegenstand der Erfindung, unabhängig von Ihrer Zusammenfassung in den Patentansprüchen und deren Rückbezügen sowie unabhängig von ihrer Beschreibung bzw. Darstellung in der Zeichnung.

Die Figuren der Zeichnung zeigen das Ausführungsbeispiel einer erfindungsgemäßen Fördervorrichtung in jeweils einer schematischen Darstellungsweise, wobei die Erfindung nicht auf dieses Ausführungsbeispiel beschränkt ist.

Die Darstellungen sind weder maßstabs- noch detailgetreu, sondern zur besseren Übersicht auf die das Verständnis unterstützenden Bestandteile bzw. Elemente reduziert.

Es zeigt:
- Fig. 1: das Ausführungsbeispiel einer erfindungsgemäßen Fördervorrichtung anhand einer ersten Betriebsphase in schematischer Darstellungsweise in einer Seitenansicht,
- Fig. 2: das Ausführungsbeispiel einer erfindungsgemäßen Fördervorrichtung aus Fig. 1 anhand einer zweiten Betriebsphase in gleicher Darstellungsweise wie in Fig. 1,
- Fig. 3: das Ausführungsbeispiel einer erfindungsgemäßen Fördervorrichtung aus Fig. 1 anhand einer dritten Betriebsphase in gleicher Darstellungsweise wie in Fig. 1,
- Fig. 4: das Ausführungsbeispiel einer erfindungsgemäßen Fördervorrichtung aus Fig. 1 anhand einer vierten Betriebsphase in gleicher Darstellungsweise wie in Fig. 1,
- Fig. 5: das Ausführungsbeispiel einer erfindungsgemäßen Fördervorrichtung aus Fig. 1 anhand einer fünften Betriebsphase in gleicher Darstellungsweise wie in Fig. 1,
- Fig. 6: das Ausführungsbeispiel einer erfindungsgemäßen Fördervorrichtung aus Fig. 1 anhand einer sechsten Betriebsphase in gleicher Darstellungsweise wie in Fig. 1, die der in Fig. 1 gezeigten ersten Betriebsphase gleicht,
- Fig. 7: das Ausführungsbeispiel einer erfindungsgemäßen Fördervorrichtung aus Fig. 1 in schematischer Darstellungsweise in einer in Fig. 1 durch A gekennzeichneten Ansicht.

In den Figuren sind gleiche oder sich entsprechende Bauteile/Bestandteile bzw. Elemente mit den gleichen Bezugszeichen versehen. Aus Gründen einer besseren Übersicht sind in den Figuren nicht stets alle Bezugszeichen eingetragen. Eine Korrespondenz zwischen den betreffenden Bauteilen/Bestandteilen bzw. Elementen ist jedoch durch die gleiche Darstellungsweise bzw. eine der betreffenden Ansicht gemäße Darstellungsweise gegeben.

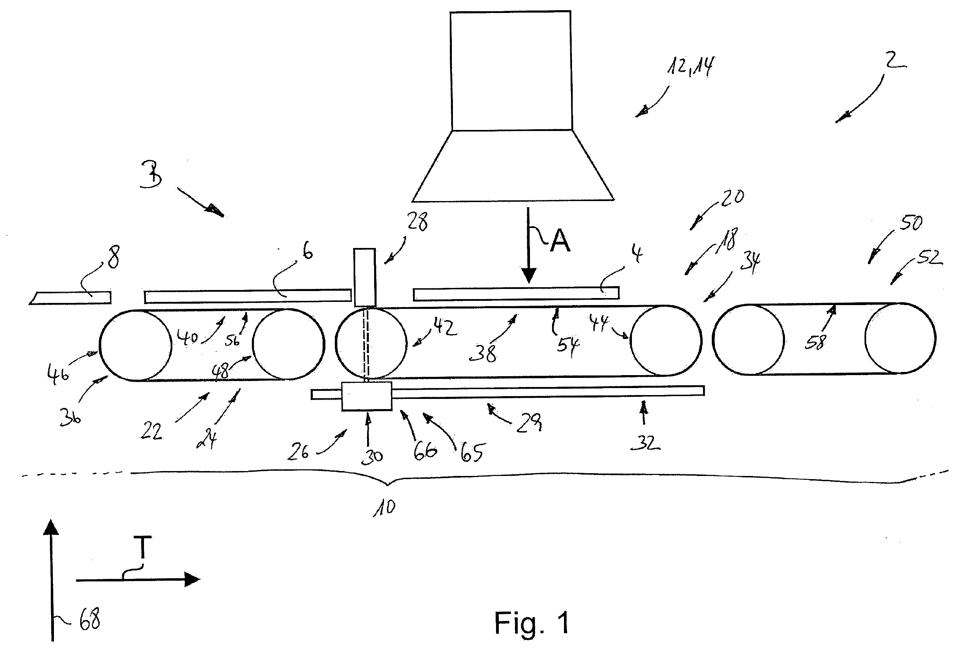

Fig.1 zeigt ein Ausführungsbeispiel einer erfindungsgemäßen Fördervorrichtung 2 (nachfolgend auch verkürzt als Fördervorrichtung 2 bezeichnet) zur Förderung von Werkstücken 4,6,8 insbesondere Leiterplatten, in Förderrichtung T entlang einer Förderstrecke 10.

Die Fördervorrichtung 2 bzw. die Förderstrecke 10 ist Bestandteil einer Fertigungslinie (nicht gezeigt) und führt damit den Bearbeitungsstationen 12 die betreffenden Werkstücke 2,4,6 zur Bearbeitung zu.

Erfindungsgemäß umfasst eine Bearbeitungsstation 12 auch die Funktionen einer Prüfstation 14 für die Werkstückprüfung.

Die in Fig. 1 abgebildete Bearbeitungsstation 12 dient der Prüfung von Leiterplatten mit ihrer besonderen Ausprägung als Wafer 4,6,8, wobei die Prüfung eines Wafers 4,6,8 insbesondere in diesem Ausführungsbeispiel der Erfindung durch ein optisches Prüfsystem 16 erfolgt. Die dabei erfassten Daten werden durch eine Auswertungseinrichtung entsprechend den Vorgaben ausgewertet, um die Qualität des Werkstückes 4,6,8 bzw. Wafers 4,6,8 festzustellen. Vorgenannte Bestandteile ohne Bezugszeichen sind nicht dargestellt.

Die Fördereinrichtung 2 ist ausgestattet mit ersten Fördermitteln 18 zur Werkstückförderung entlang einer ersten Teilstrecke 20 der Förderstrecke 10 und mit zweiten Fördermitteln 22 zur Werkstückförderung entlang einer zweiten Teilstrecke 24 der Förderstrecke 10, die der ersten Teilstrecke 20 in Förderrichtung T direkt vorgeordnet ist , um der ersten Teilstrecke 20 Werkstücke 4,6,8 zuzuführen.

Die Fördereinrichtung 2 ist dadurch gekennzeichnet, dass sie Separationsmittel 26 aufweist, die dazu dienen, wenigstens abschnittsweise entlang der ersten Teilstrecke 20 der Förderstrecke 10 ein Werkstück 2,4 von einem in Förderrichtung T direkt nachfolgenden Werkstück 4,6 zu separieren.

Dazu weisen die Separationsmittel 26 einen Abstandhalter 28 auf, der in Förderrichtung T zwischen einer Anfangsposition 30 und einer in Förderrichtung T dazu beabstandeten Endposition 32 derart bewegbar und durch Steuerungsmittel (nicht gezeigt), mit denen dieser steuerungstechnisch bzw. signaltechnisch verbunden ist, derart steuerbar ist, dass der Abstandhalter 28 nach Passieren der Anfangsposition 30 durch das Werkstück 4,6,8 in einen Aktivmodus wechselt, in dem es dem Werkstück 4,6,8 in Förderrichtung T nachgeordnet folgt und dabei zwischen dem Werkstück 4,6 und dem diesem nachgeordneten Werkstück 6,8 einen Mindestabstand ausbildet, und bei Erreichen der Endposition 32 in einen Inaktivmodus wechselt, in dem der Abstandshalter 28 in die Anfangsposition 30 zurückkehrt.

Der Abstandhalter 28 bildet in diesem Ausführungsbeispiel der Erfindung den Mindestabstand rein mechanisch bzw. durch seine geometrischen Abmessungen aus, indem der Bestandteil des Abstandhalters 28, mit dem dieser zur Ausbildung eines Mindestabstandes in mechanischen Kontakt tritt mit dem Werkstück 2,4 bzw. mit dem diesem nachfolgenden Werkstück 4,6, durch seine Abmessung in Förderrichtung T den Mindestabstand bestimmt. Der vorgenannte mechanische Kontakt bzw. eine Berührung eines Werkstückes 4,6,8 erfolgt wenigstens mittels eines Abschnittes des Abstandshalters (28).

Die Bestimmung des Mindestabstandes durch den Abstandhalter 28 kann allerdings auch elektronisch bzw. in einer Kombination aus elektronischer bzw. mechanischer Beabstandung der vorgenannten Werkstücke 4,6,8 erfolgen.

Dazu ist es möglich, dass eine Berührung des Abstandhalters 28 mit dem Werkstück 4,6,8 vermieden wird, indem der Abstandhalter 28 berührungsfrei dem Werkstück 4,6,8 in Förderrichtung T im Aktivmodus folgt. Eine Berührung des Werkstückes 4,6,8 ist im Wesentlichen auf die Fälle beschränkt, dass Schlupf zwischen der Bewegung des Werkstücks 4,6,8 in Förderrichtung T und der tatsächlichen Werkstückförderung insbesondere durch die ersten Fördermittel auftritt bzw. ein in Förderrichtung T dem Werkstück 4,6,8 nachfolgendes Werkstück 6,8 sich nähert und eine Kollision zwischen den jeweiligen Werkstücken 4,6,8 droht. Analoges gilt bei einem Ausfall der Werkstückförderung 4,6,8 durch die ersten Fördermittel 18.

Dabei ist der Abstandshalter durch eine Linearführung 29 für eine Bewegung in Förderrichtung (T) zwischen einer Anfangsposition 30 und einer Endposition 32 geführt.

Diese Art der Nachführung des Abstandshalters 28 kann daher auf einer Sensorik (nicht dargestellt) beruhen, die die einzelnen Positionen von Abstandhalter 28 und Werkstück 4,6,8 erfasst und die Steuerungsmittel (nicht dargestellt) die Bewegung des Abstandhalters 28 entsprechend steuert.

Für die Prüfung des Werkstückes 4,6,8 durch die Bearbeitungs- bzw. Prüfstation 12,14 ist die Förderung des Werkstückes 4,6,8 durch die ersten Fördermittel 18 auszusetzen. Demgemäß erfolgt die Förderung des Werkstückes 4,6,8 diskontinuierlich und daher intermittierend. Dazu sieht die Fördervorrichtung 2 vor, das die Werkstückförderung wenigstens durch die ersten Fördermittel 18 intermittierend erfolgt, wobei die Förderung des Werkstückes 4,6,8 durch die ersten Fördermittel 18 bei Erreichen einer Ruheposition (Werkstück 4 befindet sich in Fig. 1 in einer solchen), in der die Prüfstation 16 das Werkstück 4,6,8 in einem Bearbeitungszeitraum prüft, die Förderung des Werkstückes 4,6,8 in Förderrichtung T während des Bearbeitungszeitraumes aussetzt.

Des Weiteren sieht die Fördervorrichtung 2 vor, dass die ersten Fördermittel 18 wie auch die zweiten Fördermittel 22 jeweils ausgebildet sind nach Art eines Stetigförderers 34,36 und dabei jeweils wenigstens ein, insbesondere endloses, Förderband 38,40 aufweisen.

Demgemäß erfolgt eine Förderbewegung für die Werkstückförderung bei jedem der Förderbänder 38,40 jeweils durch eine Umlaufbewegung um zwei zueinander in Förderrichtung T beabstandete achsparallele Rollen 42,44,46,48.

Der ersten Teilstrecke 20 der Förderstrecke 10 ist in Förderrichtung T eine dritte Förderstrecke 50 der Förderstrecke 10 nachgeordnet, denen Werkstücke 4,6,8 über die erste Teilstrecke 20 zugeführt werden.

Dazu sieht die Fördereinrichtung 2 dritte Fördermittel 52 zur Werkstückförderung entlang der dritten Teilstrecke 50 der Förderstrecke 10 vor, die der ersten Teilstrecke 20 in Förderrichtung T direkt nachgeordnet ist, wobei dieser die erste Teilstrecke 20 Werkstücke 4,6,8 zu deren weiteren Werkstückförderung zuführt.

Die Fördervorrichtung 2 ist ferner dadurch gekennzeichnet, dass die ersten Fördermittel 18 und die zweiten Fördermittel 24 wie auch die dritten Fördermittel 54 jeweils ein erstes endloses Förderband 54,56,58 und ein dazu quer zur Förderrichtung T beabstandetes zweites endloses Förderband 60,62,64 aufweisen, deren jeweilige umlaufende Bewegung der Förderbänder 64,56,58,60,62,64 zur Werkstückförderung durch die jeweiligen Fördermittel 18,22,52 entsprechend aufeinander abgestimmt bzw. miteinander synchronisiert sind.

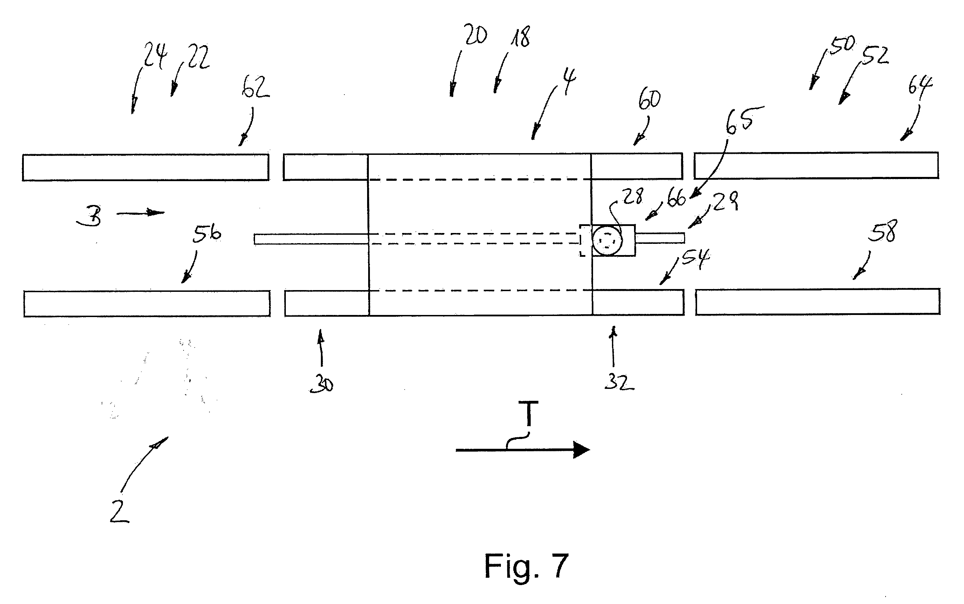

Die Anordnung ist in Fig. 7 schematisch verdeutlicht.

Bei der in Fig. 1 gezeigten Fördervorrichtung 2 ist der Abstandhalter 28 in seinem Aktivmodus wie auch im Inaktivmodus quer zur Förderrichtung T zwischen dem ersten und dem zweiten Förderband 54,56 der ersten Fördermittel 18 und gleich beabstandet zu ihnen angeordnet.

Dadurch ist eine kompakte Bauweise der Fördereinrichtung 2 möglich. Des Weiteren schränkt eine derartige Anordnung die zulässige Höhe bzw. Breite der zugeführten Werkstücke 4,6,8 nicht unnötig ein.

Für die Abstimmung der Bewegung des Abstandhalters 28 zu dem Werkstück 4,6,8, dem es im Aktivmodus nachfolgt, ist vorgesehen, dass die Bewegung des Abstandhalters 28 im Aktivmodus mit der Werkstückförderung der ersten Fördermittel 18 synchronisiert ist.

Darüber hinaus ist vorgesehen, dass die Separationsmittel 26 elektrisch betriebene Antriebsmittel (nicht gezeigt) zur Erzeugung einer Bewegung des Abstandhalters 28 zwischen Anfangsposition 30 und Endposition 32 aufweisen, um den Abstandhalter 28 dem jeweiligen Werkstück 4,6,8 durch eine entsprechende Antriebsbewegung nachzuführen und nach Erreichen der Endposition 32 in die Anfangsposition 30 zurück zu bewegen.

Dazu sind die Antriebsmittel mit den Steuerungsmitteln (nicht gezeigt) der Fördereinrichtung 2 signaltechnisch verbunden, die u. a. die Bewegung des Abstandhalters 28 steuern. Die Steuerungsmittel dienen u.a. auch der Feststellung, ob ein Werkstück die Anfangsposition 30 für den Abstandshalter 28 bzw. dessen Endposition 32 passiert hat. Dazu weist die Steuerungsmittel Sensoren auf, mit denen sie steuerungs- bzw. signaltechnisch verbunden ist. Die Sensoren können u.a. dazu dienen, ein Ergebnis des Passierens von Werkstücken (4,6,8) an vorgenannten Positionen (30,32) abzufühlen bzw. zu erfassen, worauf die Steuerungsmittel entsprechende Aktionen einzuleiten vermögen bzw. Komponenten entsprechend steuern können. Vorgenannte Bestandteile ohne Bezugszeichen sind in den Figuren nicht dargestellt.

Um den Abstandhalter 28 dem Werkstück 4,6,8 zur Ausbildung eines Mindestabstandes zu einem nachfolgendem Werkstück 6,8 nachzuführen, ist erfindungsgemäß vorgesehen, dass die Separationsmittel 26 wenigstens einen Aktor 65 aufweisen, der den Abstandhalter 28 im Aktivmodus zur Ausbildung eines Mindestabstandes zwischen dem Werkstück 4,6,8 und dem in Förderrichtung T nachfolgendem Werkstück 6,8 in die Bewegungsbahn B des Werkstückes 4,6,8 wenigstens abschnittsweise hineinbewegt und bei Erreichen der Endposition 32 in vertikaler Richtung 68 für eine Bewegung des Abstandhalter 28 von der Endposition 32 in die Anfangsposition 30 aus der Bewegungsbahn B des Werkstückes 4,6,8 hinausbewegt.

Dazu weist der Aktor 65 wenigstens eine Hub-/Senkeinrichtung 66 für den Abstandhalter 28 auf, die den Abstandhalter 28 im Aktivmodus durch eine Hubbewegung zur Ausbildung eines Mindestabstandes der Werkstücke 4,6,8 in vertikaler Richtung 68 anheben, sowie bei Erreichen der Endposition 32 in vertikaler Richtung 68 für eine Bewegung des Abstandhalter 28 von der Endposition 32 in die Anfangsposition 30 aus der Bewegungsbahn B in einen kollisionsfreien Bereich, insbesondere unterhalb des nachfolgenden Werkstückes 6,8, absenken.

In einem kollisionsfreien Bereich ist erfindungsgemäß verhindert, dass der Abstandshalter 28 mit einem Werkstück 4,6,8 kollidiert.

In Fig. 1 zeigt die Fördereinrichtung 2 in einer ersten Betriebsphase, in der das der Prüfstation 16 entlang der ersten Teilstrecke 20 der Förderstrecke 10 zugeführte Werkstück 4 einer Prüfung unterzogen wird.

Daher ist in Fig. 1 der Abstandhalter 28 in einem Aktivmodus dargestellt, in dem der Abstandhalter 28 in Förderrichtung T dem Werkstück 4 direkt nachgeordnet ist und zwischen diesem und einem dem Werkstück 4 in Förderrichtung T direkt nachgeordnetes Werkstück 6 vorgeordnet ist.

Daher ist der Abstandhalter 28 zwischen den vorgenannten Werkstücken 4,6,8 berührungsfrei zu diesen angeordnet. Der Abstandhalter 28 ist durch die Hub-/Senkeinrichtung 66 angehoben worden, nachdem das betreffende Werkstück 2,4,6 die Anfangsposition 30 für den Abstandhalter 28 passiert hat.

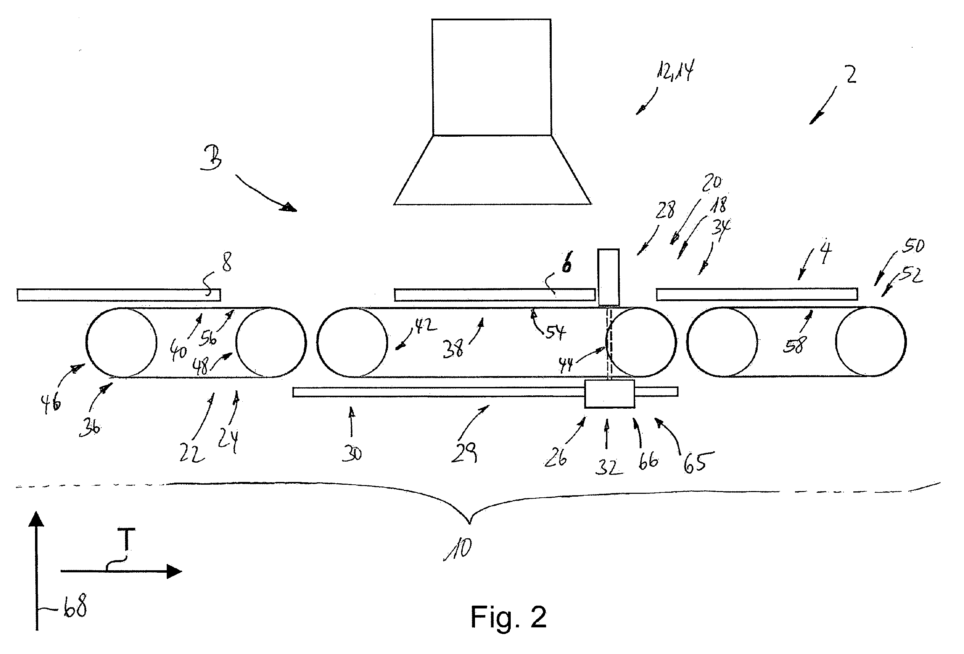

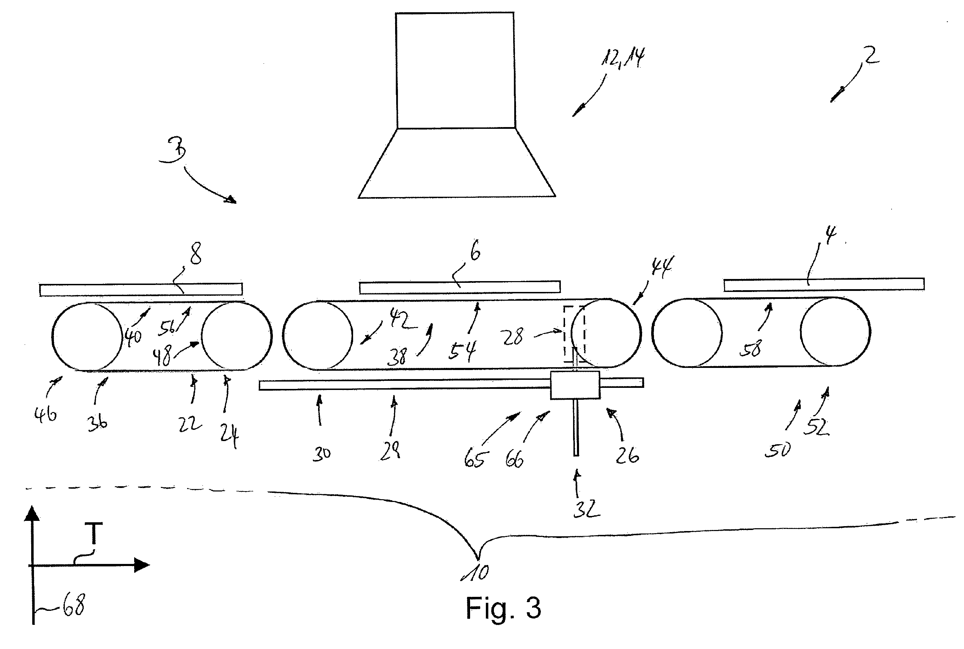

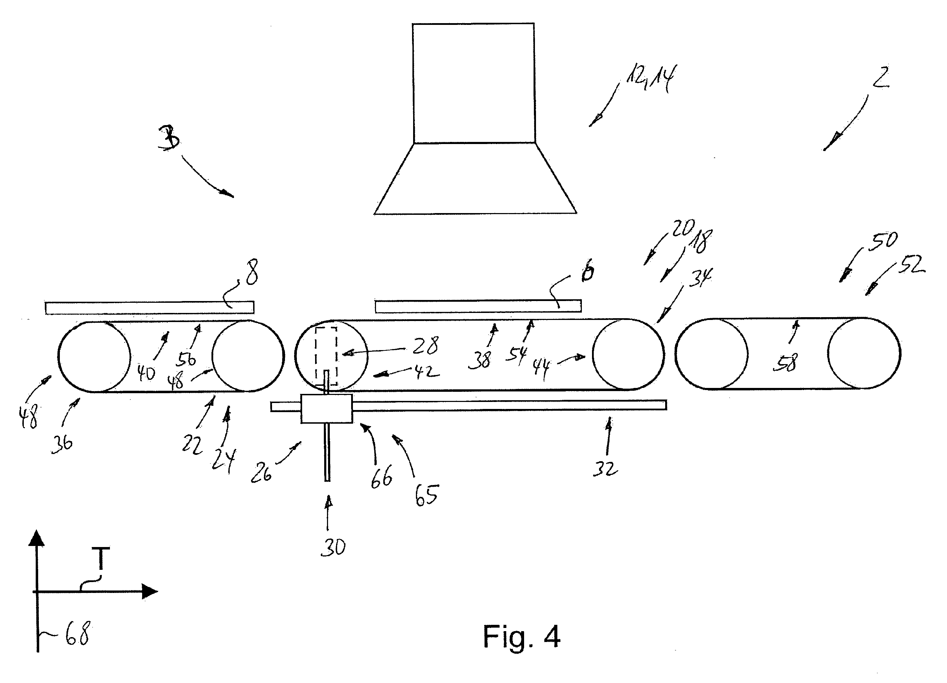

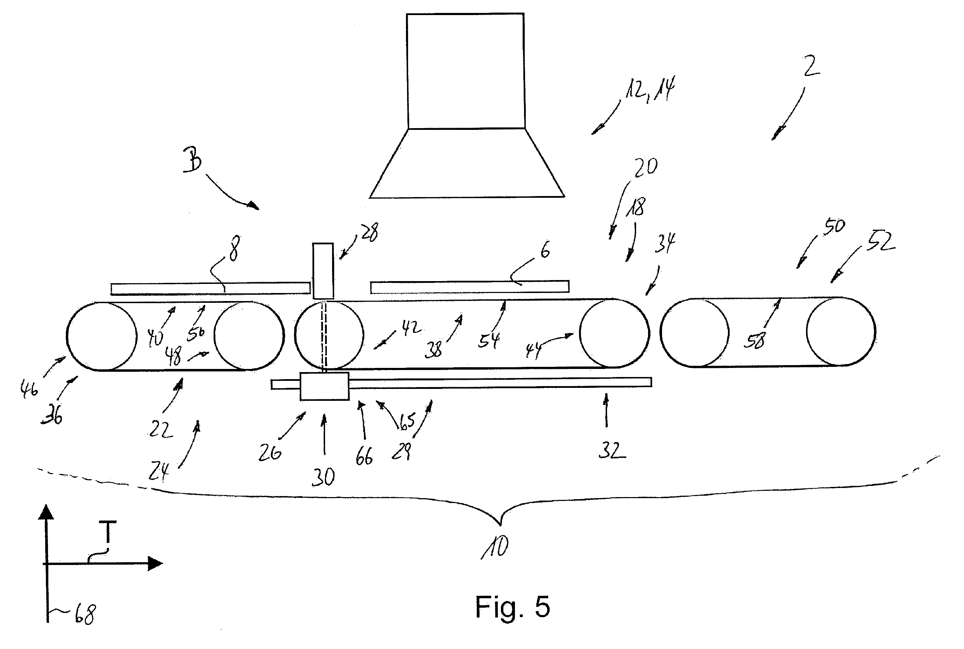

In Fig. 2 ist die Fördervorrichtung 2 aus Fig. 1 in einer zweiten Betriebsphase dargestellt. In dieser wird das Werkstück 4,6,8 in Förderrichtung T durch die ersten Fördermittel 18 gefördert und der dritten Förderstrecke 52 zugeführt. Der Abstandhalter 28 bewegt sich dazu in Richtung seiner Endposition 32. Das dem Werkstück 4,6,8 in Förderrichtung T direkt nachfolgende Werkstück 6,8 wird der ersten Teilstrecke 20 über die zweite Teilstrecke 24 zugeführt und mittels der ersten Fördermittel 18 entlang der ersten Teilstrecke 20 gefördert. Dabei erreicht das Werkstück 4,6,8 eine Ruheposition und der Abstandhalter 28 seine Endposition 32, in der dieser durch die Hub-/Senkeinrichtung 66 in vertikaler Richtung 68 abgesenkt und in seine Anfangsposition 30 zurückgeführt wird. Dieser Vorgang ist in Fig. 3 und Fig. 4 anhand eines dritten bzw. vierten Betriebszustandes der Fördereinrichtung 2 gezeigt. Daraufhin wird der Abstandhalter 28 durch die Hub-/Senkeinrichtung 66 in vertikaler Richtung 68 angehoben, um wiederum einen Mindestabstand für das dem zuvor genannten Werkstück 4 nachfolgende Werkstück 6 auszubilden, wie dies anhand eines fünften Betriebszustandes der Fördervorrichtung 2 in Fig. 5 gezeigt ist.

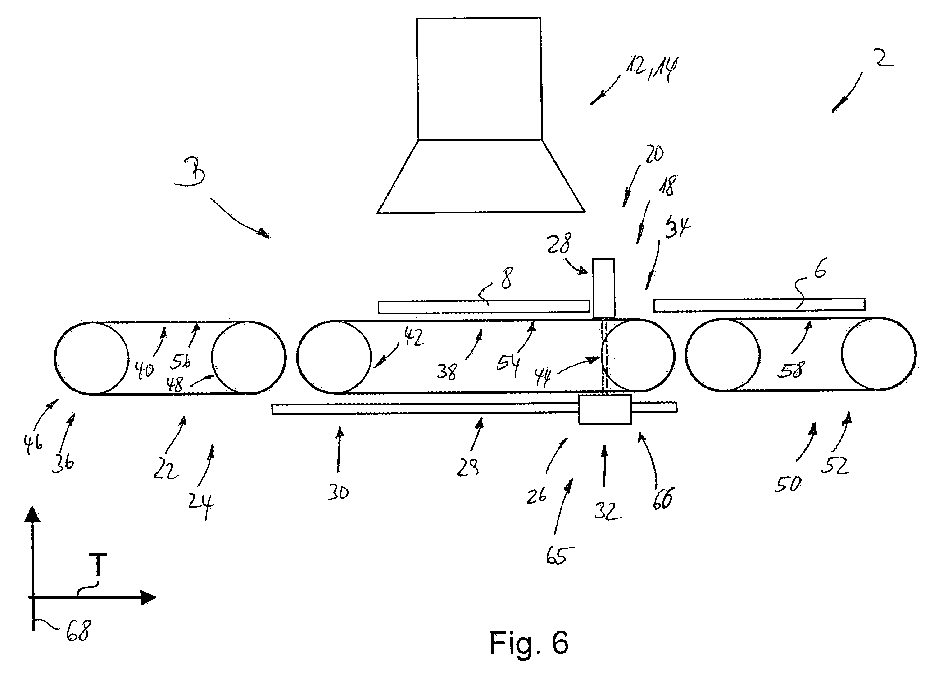

Fig. 6 zeigt einen sechsten Betriebszustand der Fördereinrichtung 2, der dem in Fig. 1 gezeigten ersten Betriebszustand gleicht.

Zur Verdeutlichung der Realisierung der vorgenannten Fördermittel 18,22,52 ist in Fig. 7 die in Fig. 1 durch A gekennzeichnete Ansicht dargestellt.

Die Erfindung ist ebenfalls geeignet, dass ihre zuvor beschriebenen Bestandteile auch in redundanter Art und Weise zu Anwendung kommen können.

## Patentansprüche

1. Fördervorrichtung (2) zur Förderung von Werkstücken (4,6,8), insbesondere Leiterplatten, in Förderrichtung entlang einer Förderstrecke (10),
mit ersten Fördermitteln (18) zur Werkstückförderung entlang einer ersten Teilstrecke (20) der Förderstrecke (10)
und mit zweiten Fördermitteln (22) zur Werkstückförderung entlang einer zweiten Teilstrecke (24) der Förderstrecke (10), die der ersten Teilstrecke (20) in Förderrichtung (T) vorgeordnet ist, um der ersten Teilstrecke (20) Werkstücke (4,6,8) zuzuführen,
**gekennzeichnet**
**durch** Separationsmittel (26), die wenigstens abschnittsweise entlang der ersten Teilstrecke (20) ein Werkstück (4,6,8) von einem in Förderrichtung (T) dem Werkstück (4,6,8) nachfolgendes Werkstück (6,8) separieren,
wobei die Separationsmittel (26) wenigstens einen Abstandhalter (28) aufweisen, der in Förderrichtung (T) zwischen einer Anfangsposition (30) und einer in Förderrichtung (T) dazu beabstandeten Endposition (32) derart bewegbar und durch Steuerungsmittel derart steuerbar ist,
dass der Abstandhalter (28) nach Passieren der Anfangsposition (30) durch das Werkstück (4,6,8) in einen Aktivmodus wechselt, in dem es dem Werkstück (4,6,8) in Förderrichtung (T) nachgeordnet folgt und dabei zwischen dem Werkstück (4,6,8) und dem diesem Werkstück (4,6,8) in Förderrichtung T nachgeordneten Werkstück (6,8) einen Mindestabstand ausbildet, und bei Erreichen der Endposition (32) in einen Inaktivmodus wechselt, in dem der Abstandshalter (28) in die Anfangsposition (30) zurückkehrt.

2. Fördervorrichtung nach Anspruch 1, **dadurch gekennzeichnet, dass** die Werkstückförderung wenigstens durch das ersten Fördermittel (18) intermittierend ist, wobei die Förderung des Werkstückes (4,6,8) durch das erste Fördermittel (18) bei Erreichen einer Ruheposition, in der eine Bearbeitungsstation (12), insbesondere eine Prüfstation (14), das Werkstück (4,6,8) in einem Bearbeitungszeitraum bearbeitet bzw. prüft, die Förderung des Werkstückes (4,6,8) in Förderrichtung (T) während des Bearbeitungszeitraumes aussetzt oder mit einer geänderten Fördergeschwindigkeit des Werkstückes (4,6,8) erfolgt.

3. Fördervorrichtung nach Anspruch 1 oder 2, **dadurch gekennzeichnet, dass** wenigstens die ersten Fördermittel (18) ausgebildet sind nach Art eines Stetigförderers (34,36), und insbesondere wenigstens ein, vorzugsweise endloses, Förderband (38,54,60) aufweisen, das eine Förderbewegung für die Werkstückförderung durch eine Umlaufbewegung um wenigstens zwei zueinander in Förderrichtung (T) beabstandete, insbesondere achsparallele, Rollen (42,44) erzeugt.

4. Fördervorrichtung nach Anspruch 3, **dadurch gekennzeichnet, dass** wenigstens die ersten Fördermittel (18) wenigstens ein erstes, insbesondere endloses, Förderband (54) und wenigstens ein dazu quer zur Förderrichtung (T) beabstandetes zweites, insbesondere endloses, Förderband (60) aufweisen, deren jeweilige Bewegung für die Werkstückförderung aufeinander abgestimmt sind.

5. Fördervorrichtung nach einem der vorhergehenden Ansprüche, **dadurch gekennzeichnet, dass** der Abstandhalter (28) wenigstens in seinem Aktivmodus quer zur Transportrichtung (T) zwischen dem ersten und dem zweiten Förderband (54,60), insbesondere gleich beabstandet, zu den Förderbändern (54,60) angeordnet ist.

6. Fördervorrichtung nach einem der vorhergehenden Ansprüche, **dadurch gekennzeichnet, dass** die Bewegung des Abstandhalters (28) im Aktivmodus mit der Werkstückförderung des ersten Fördermittels (18) abgestimmt bzw. synchronisiert ist.

7. Fördervorrichtung nach einem der vorhergehenden Ansprüche, **dadurch gekennzeichnet, dass** die Separationsmittel (26) wenigstens eine Linearführung (29) aufweisen, durch den der Abstandhalter für eine Bewegung zwischen Anfangsposition (30) und Endposition (32) geführt ist.

8. Fördervorrichtung nach einem der vorhergehenden Ansprüche, **dadurch gekennzeichnet, dass** die Separationsmittel (26), insbesondere elektrisch betriebene, Antriebsmittel zur Erzeugung einer Bewegung des Abstandhalters (28) zwischen Anfangsposition (30) und Endposition (32) aufweisen.

9. Fördervorrichtung nach einem der vorhergehenden Ansprüche, **dadurch gekennzeichnet, dass** die Separationsmittel (26) wenigstens einen Aktor (65) aufweisen, der den Abstandhalter (28) zur Ausbildung eines Mindestabstandes zwischen dem Werkstück (4,6,8) und dem in Förderrichtung (T) nachfolgendem Werkstück (6,8) in die Bewegungsbahn (B) des Werkstückes (4,6,8) wenigstens abschnittsweise hineinbewegt und bei Erreichen der Endposition (32) in vertikaler Richtung (68) für eine Bewegung des Abstandhalter (28) von der Endposition (32) in die Anfangsposition (30) aus der Bewegungsbahn (B) des Werkstückes (4,6,8) hinausbewegt.

10. Fördervorrichtung nach Anspruch 9, **dadurch gekennzeichnet, dass** der Aktor (65) wenigstens eine Hub-/Senkeinrichtung (66) für den Abstandhalter (28) aufweist, die den Abstandhalter (28) im Aktivmodus durch eine Hubbewegung zur Ausbildung eines Mindestabstandes der Werkstücke (4,6,8) in vertikaler Richtung (68) anheben, sowie bei Erreichen der Endposition (32) in vertikaler Richtung (68) für eine Bewegung des Abstandhalter (28) von der Endposition (32) in die Anfangsposition (30) aus der Bewegungsbahn (B), insbesondere unterhalb des nachfolgenden Werkstückes (6,8), absenken.

11. Bearbeitungsstation (12) zur Bearbeitung eines Werkstückes (4,6,8)
mit wenigstens ersten Fördermittel (18) zur Werkstückförderung entlang einer ersten Teilstrecke (20) einer Förderstrecke (10), die das Werkstück (4,6,8) einer Bearbeitungseinrichtung für die Bearbeitung des Werkstückes zuführt,
wobei der ersten Teilstrecke (20) eine zweite Teilstrecke (24) Werkstücke (4,6,8) zur Werkstückförderung durch die ersten Fördermittel (18) zuführt,
**gekennzeichnet**
**durch** Separationsmittel (26), die wenigstens abschnittsweise entlang der ersten Teilstrecke (20) der Förderstrecke (10) ein Werkstück (4,6,8) von einem in Förderrichtung (T) nachfolgenden Werkstück (6,8) separieren,
wobei die Separationsmittel (26) wenigstens einen Abstandhalter (28) aufweisen, der in Förderrichtung (T) zwischen einer Anfangsposition (30) und einer in Förderrichtung (T) dazu beabstandeten Endposition (32) derart bewegbar und durch Steuerungsmittel derart steuerbar ist,
dass der Abstandhalter (28) nach Passieren der Anfangsposition (30) durch das Werkstück in einen Aktivmodus wechselt, in dem es dem Werkstück (4,6,8) in Förderrichtung (T) nachgeordnet folgt und dabei zwischen dem Werkstück (4,6,8) und dem ihm nachgeordneten Werkstück (6,8) einen Mindestabstand ausbildet, und bei Erreichen der Endposition (32) in einen Inaktivmodus wechselt und in die Anfangsposition (30) zurückkehrt.

12. Bearbeitungsstation nach Anspruch 11 und einem der Ansprüche 2 bis 10.
